# EUROPÄISCHE PATENTSCHRIFT

(11) **EP 0 254 070 B1**
(45) Veröffentlichungstag und Bekanntmachung des Hinweises auf die Patenterteilung: **13.01.1993**
(21) Anmeldenummer: 87109154.2
(22) Anmeldetag: 25.06.1987
(51) Int. Cl.: H05K 1/05, H01C 7/02, H01L 23/14

(54) **Elektro-Bauelement**
Electrical device
Dispositif électrique

(30) Priorität: 24.07.1986 DE 3625087
(43) Veröffentlichungstag der Anmeldung: 27.01.1988
(73) Patentinhaber: E.G.O. Elektro-Geräte Blanc u. Fischer, D-75032 Oberderdingen (DE)
(72) Erfinder: Lorenz, Josef, Dr.rer.nat.Dipl.-Ing., D-7519 Oberderdingen (DE); Kicherer, Robert, Ing.grad., D-7519 Oberderdingen (DE); Keller, Ewald, D-7129 Zaberfeld (DE)
(74) Vertreter: Patentanwälte Ruff, Beier, Schöndorf und Mütschele

(56) Entgegenhaltungen:
- EP-A- 0 048 406
- DE-A- 3 501 372
- IBM TECHNICAL DISCLOSURE BULLETIN, Band 25, Nr. 2, Juli 1982, Seiten 653-656, New York, US; N.G. AAKALU et al.: "Laminated metal core circuit card with controlled thermal expansivity"

## Beschreibung

Die Erfindung betrifft ein Elektro-Bauelement nach dem Oberbegriff des Anspruchs 1 und ein Verfahren zu seiner Herstellung.

Sogenannte Dickschicht-Widerstände oder gedruckte Schaltungen haben üblicherweise einen Träger aus Isoliermaterial, beispielsweise auf der Basis von Aluminiumoxid. Es ist auch schon vorgeschlagen worden, derartige Bauelemente mit Trägern aus Metallen oder Metallegierungen herzustellen. In einem Falle wurden hochlegierte Stähle, beispielsweise rostfreier Stahl, verwendet, der mit einer isolierenden Emailschicht versehen wurde, auf der die gedruckte Schaltung angebracht wurde.

Hochlegierte Stähle sind nicht nur sehr teuer, sondern haben auch eine relativ geringe Wärmeleitfähigkeit. Ferner können aus der Emailschicht Alkali-Bestandteile in die darauf befindlichen Leiterbahnen und Widerstände eindiffundieren, was in den meisten Anwendungsbereichen unzulässig ist.

Aus dem IBM Technical Disclosure Bulletin Vol. 25, No. 2, Juli 1982; Artikel "LAMINATED METAL CORE CIRCUIT CARD WITH CONTROLLED THERMAL EXPANSIVITY", Seiten 653 bis 656, ist bekanntgeworden, einen Träger für Silikon-Chips nach Art eines Sandwichs aus Schichten herzustellen, die aus wenigstens einer INVAR-Schicht und einer oder mehreren Schichten aus anderen Metallen, unter denen auch Aluminium genannt ist, bestehen. Auf die Oberflächenschicht soll eine Porzellan aufgebrannt werden, das dann seinerseits Träger für Leiterbahnen ist. Dieses Träger-Sandwich soll eine Längenausdehnungszahl erreichen, die der von Silikon-Chips entspricht, um diese bei ihrer Anbringung auf der Oberfläche nicht zu gefährden.

Die DE-A1-35 01 372 zeigt ein Substrat für Leiterplatten, bestehend aus einem Kern aus einer Eisen-Nickel-Legierung, die beiderseitig mit Aluminium plattiert ist. Dieses Substrat soll an der Außenseite mit einer Eloxalschicht versehen sein. Dabei soll die Eloxalschicht die Aufgabe der Isolierschicht übernehmen und soll somit direkt Basis für Anbringung von Leiterbahnen durch Beschichtungstechniken etc. sein.

Aufgabe der Erfindung ist es, ein Elektro-Bauelement der eingangs erwähnten Art und ein Verfahren zu seiner Herstellung zu schaffen, das aus kostengünstigen Materialien leicht herstellbar ist und bei guten Funktionseigenschaften und vielseitiger Anwendbarkeit einen guten Halt der Leiterbahnen auf dem Träger gewährleistet.

Diese Aufgabe wird gemäß der Erfindung durch den Anspruch 1 gelöst.

Die zwischen der Isolierschicht und dem Basismaterial des Trägers vorgesehene Oberflächenschicht aus Aluminium schafft die Möglichkeit, die Isolierschicht auch auf einem Träger aus beispielsweise un- oder niedriglegiertem Stahl, z. B. üblichem Walzstahlblech, fest zu verankern, obwohl die Brenntemperaturen zur Anbringung der Schichten den Werkstoff Aluminium nicht zulassen. Das Aluminium geht allerdings mit dem Stahl des Trägers eine intermetallische Verbindung ein, die nicht nur für einen guten Halt sorgt, sondern auch eventuell nicht mit der Isolierschicht überzogene Teile des Trägers gegen Korrosion schützt. Dabei entsteht im Außenbereich der Oberflächenschicht, d. h. im Grenzbereich zwischen Aluminiumschicht und Isolierschicht, die vorzugsweise eine alkalifreie Schicht auf Glasbasis ist, eine Verankerungszone für die Isolierschicht. Die Aluminiumschicht sorgt für eine um ein Vielfaches höhere Wärmeleitfähigkeit des Trägers, als z. B. diejenige von hochlegiertem Stahl, auch gegenüber dem Träger-Grundmaterial. So vereinigt dieser Träger in idealer Weise die Steifigkeit von Stahl und die hohe Wärmeleitfähigkeit, Korrosionsbeständigkeit und ausgezeichnete Haftvermittlung zu Glas von Aluminium.

Das Elektro-Bauelement kann universell eingesetzt werden. Besonders vorteilhaft ist es als Heizwiderstand zu verwenden, wobei es durch seine relativ dünne elektrische Isolierschicht zwischen Leiterbahn und Träger sowie die Großflächigkeit des Trägers und seiner guten Wärmeverteilung ideale Strahlungs- und Konvektions-Wärmeübertragungseigenschaften hat. Das Bauelement kann unmittelbar als Einschub und auch als tragendes Bauelement in Raumheizgeräten eingesetzt werden. Auch für andere Beheizungszwecke ist das Bauelement vorteilhaft, z.B. für die Beheizung von Backöfen, bei denen das Bauelement eine Muffelwandung mit außen- und/oder innenliegenden Heizwiderständen bilden könnte. Auch für die Beheizung von Heiz- oder Wärmeplatten aus Eisen oder Stahl könnte das Bauelement mit an der Unterseite angeordneten Heizwiderständen vorteilhaft verwendet werden. Es ist aber auch für andere elektrische und elektronische Verwendungen einsetzbar. So können die Leiterbahnen zum Teil Leitungsstränge und zum Teil Widerstände bilden und ggf. auch Lötmaterialschichten enthalten oder Metallisierungen, mit denen andere Bauelemente, beispielsweise Chips, an dem Träger mechanisch und elektrisch angeschlossen werden. Auch dort sorgt das kostengünstige und gleichzeitig gut wärmeableitende Material für ideale Voraussetzungen.

Das Herstellungsverfahren nach Anspruch 10 ermöglicht eine einfache Herstellung im Druckverfahren, vorzugsweise Siebdruck. Bevorzugt ist der Träger ein handelsübliches Walzstahlblech. Es wäre jedoch auch denkbar, andere Bauteile, beispielsweise tragende Bauteile von Geräten, als Träger für Leiterbahnen zu verwenden. Dabei wird durch das Einbrennen der Schichten gleichzeitig eine Wärmebehandlung des Trägermaterials vorgenommen, die dieses spannungsfrei macht.

Weitere Vorteile und Merkmale der Erfindung gehen aus den Unteransprüchen sowie der Beschreibung und Zeichnung hervor, wobei diese Merkmale einzeln oder in Kombination miteinander vorteilhafte Versionen der Erfindung ergeben können. Ausführungsbeispiele der Erfindung sind in der Zeichnung dargestellt und werden im folgenden näher erläutert. Es zeigen:
- Fig. 1: eine Draufsicht auf ein Elektro-Bauelement,
- Fig. 2: einen stark vergrößerten Teilschnitt durch das Bauelement,
- Fig. 3: einen Anschlußbereich eines doppelseitig beschichteten Bauelementes,
- Fig. 4: ein vergrößertes Detail aus Fig. 3,
- Fig. 5: einen Anschluß eines einseitig beschichteten Bauelementes,
- Fig. 6: ein Raumheizelement, das Elektro-Bauelemente beinhaltet und
- Fig. 7: ein mit elektrischen Bauteilen bestücktes Bauelement im schematischen Teilschnitt.

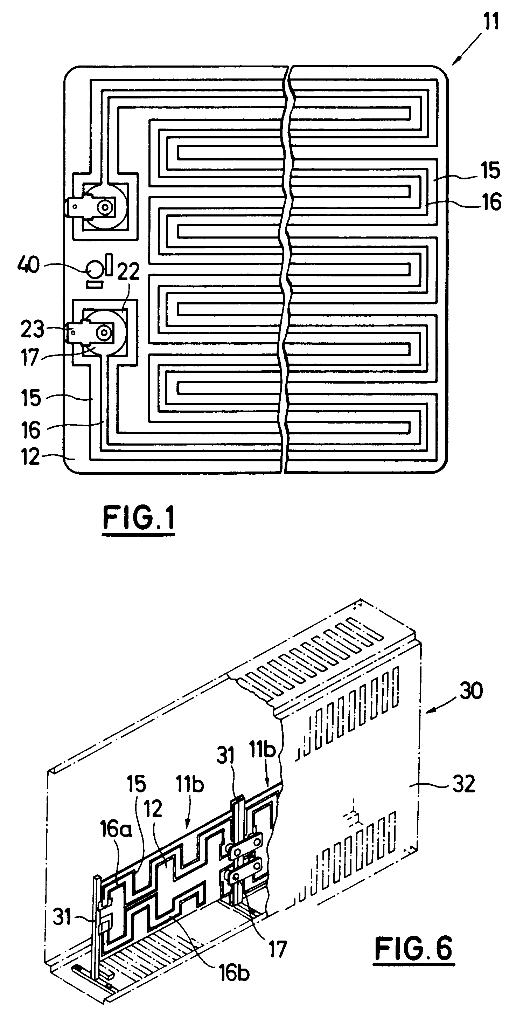

Das in Fig. 1 bis 4 gezeigte Elektro-Bauelement 11 besitzt einen Träger 12, der aus einem aluminierten Stahlblech handelsüblicher, niedrig- oder unlegierter Qualität besteht. Die Aluminierung kann eine Alu-Plattierung oder eine Feueraluminierung sein. Derartige Stahlbleche werden beispielsweise von der Firma Thyssen AG, D-4100 Duisburg 11 unter der Bezeichnung "fal" vertrieben. Dabei ist auf das Basis-Stahlblech 13 vorzugsweise auf beiden Seiten eine Aluminium-Oberflächenschicht 14 aufgebracht, die vorzugsweise zwischen 5 und 80 µm, vorzugsweise zwischen 15 und 40 µm dick ist.

In Bereichen, die später Leiterbahnen 16 tragen sollen, ist eine Isolationsschicht 15 auf den Träger 12 aufgebracht, und zwar auf beiden Seiten des Trägers, wobei sich die Bereiche nicht miteinander decken müssen. Die Leiterbahn 16 und damit auch die Isolationsschicht 15 verläuft zwischen zwei Anschlüssen 17 im wesentlichen mäanderförmig die Oberfläche des Trägers 12 im wesentlichen gleichmäßig bedeckend, wobei die Isolierschicht breiter ist als die Leiterbahnen und auch zwischen den Isolierschichten noch ein Abstand verbleibt. Dies beugt eventuellen Spannungsrissen in der Isolierschicht vor und sorgt dafür, daß möglichst viel von der gut wärmeabgebenden Metalloberfläche frei bleibt.

In Anwendungen, bei denen keine Spannungsrisse in der Isolationsschicht 15 auftreten, kann die Isolationsschicht auch geschlossen sein.

Bei dem in Fig. 1 dargestellten Bauelement 11 handelt es sich um ein Raumheizelement, das beispielsweise auf einer Trägerfläche von ca. 300 cm² eine Leistung von 200 bis 500 Watt Wärmeleistung bringt. Durch entsprechende Wahl des Werkstoffes für die als Dickschichtwiderstand ausgebildete Leiterbahn 16, beispielsweise Nickel, kann dieser eine erhebliche PTC-Wirkung haben und bei einer anfänglichen Leistung in der Größenordnung von 500 Watt diese bei Erwärmung auf 250 bis 300 Watt selbsttätig herunterregeln.

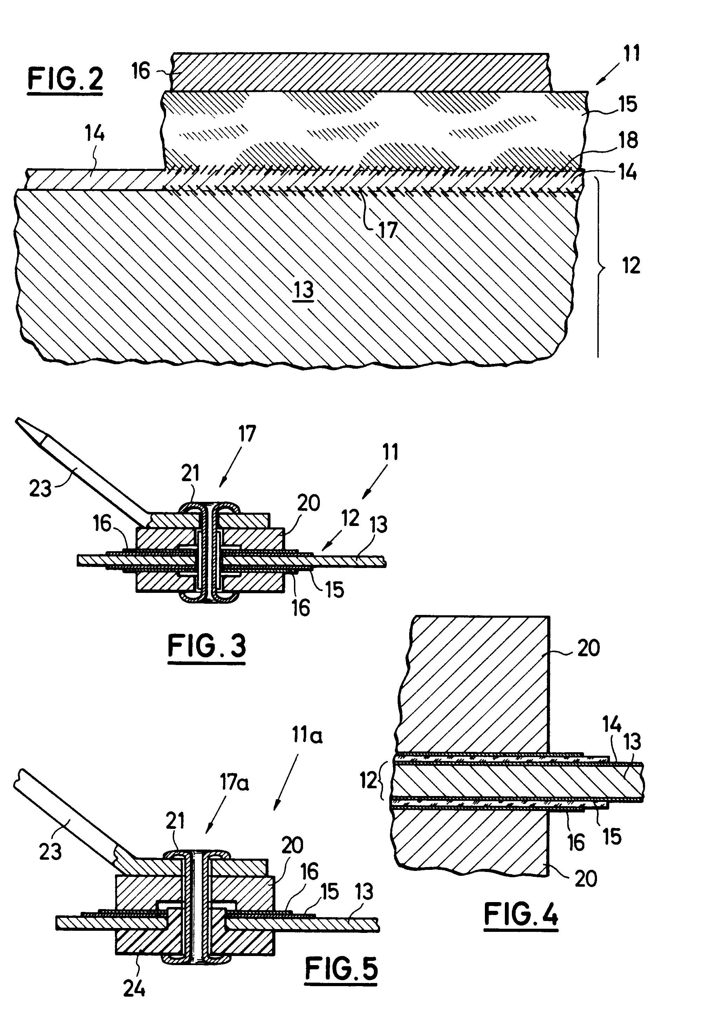

Aus Fig. 2 ist der Schichtaufbau des Bauelementes besser zu erkennen. Die Aluminium-Oberflächenschicht 14 des unbeschichteten Trägers (Fig. 2, links) wandelt sich durch Wärmebehandlung, beispielsweise beim Einbrennen der Isolierschicht 15 und Leiterbahn 16, so um, daß sie in ihrem an das Basismaterial 13 angrenzenden Bereich eine intermetallische Verbindungszone 7 zwischen A1 und Fe bildet, während sich zum Äußeren der Oberflächenschicht 14 hin eine Grenzzone 18 bildet, die eine Aluminiumoxid-(A1₂O₃)-Anreicherung enthält.

Darauf ist die Isolierschicht 15 aufgebracht, die überwiegend aus Glas besteht. Ihre Dicke hängt von den von ihr geforderten Isolationseigenschaften ab und beträgt meist mehr als 20 µm, bevorzugt ca. 50 µm. Auf der Isolierschicht 15 liegt die Leiterbahn 16, die, ebenso wie die Glasschicht, als aufgeschmolzene bzw. -gebrannte Schicht hergestellt ist und außer metallischen Bestandteilen, beispielsweise Nickel, auch Glasanteile zur Bindung enthält.

Die Schichtdicke der Leiterbahn hängt von den geforderten elektrischen Eigenschaften ab und kann beispielsweise in der Größenordnung von 20 µm liegen. Die Dicke des Basisblechs, das den Träger 12 bildet, kann vorzugsweise zwischen 0,5 und 1,5 mm liegen, in Sonderfällen darunter oder darüber.

Fig. 3 zeigt den Anschluß 17 des doppelseitig mit Leiterbahnen 16 versehenen Trägers 11. Zwei topfförmige Anschlußstücke 20 aus leitendem Material werden durch einen Mittelniet 21 (oder eine entsprechende Schraube) an verbreiterte Bereiche 22 der Leiterbahn 16 gepreßt. Der Niet läuft durch eine Lochung des Trägers hindurch und kann an seiner Außenseite isoliert sein. Der Niet drückt an ein Anschlußstück 20 auch eine Anschlußfahne 23 an, die schräg abgewinkelt ist und einen Steckanschluß für eine Stromzuleitung bildet.

Fig. 4 zeigt eine etwas vergrößerte und in den Verhältnissen der Schichtdicken realistischere Darstellung eines Teils des Anschlusses 17 und des Trägers 11. Fig. 5 zeigt einen Anschluß 17a eines einseitig beschichteten Trägers 11a. Dabei hält der Mittelniet 21 außer dem metallischen Anschlußstück 20 auf der unbeschichteten Rückseite ein ringförmiges Isolierstück 24 angepreßt. Im übrigen gleicht der Anschluß dem nach Fig. 3, 4. Wegen der guten Wärmeverteilung im Träger 11 reicht an sich ein einseitig beschichteter Träger für Raumklimageräte aus. Die zweiseitige Beschichtung schafft allerdings die Möglichkeit, in zwei Stufen zu schalten. In diesem Falle sollten jedoch beide Seiten zumindest je einen Anschluß haben, der von dem der anderen Seite isoliert ist, was durch zwei entsprechend versetzte Anschlüsse nach Art des in Fig. 5 dargestellten geschehen kann. Ferner sind beliebige Anschlußarten möglich, beispielsweise auch unmittelbar auf die Leiterbahn aufgelötete oder anderweitig angepreßte oder angeformte Anschlüsse.

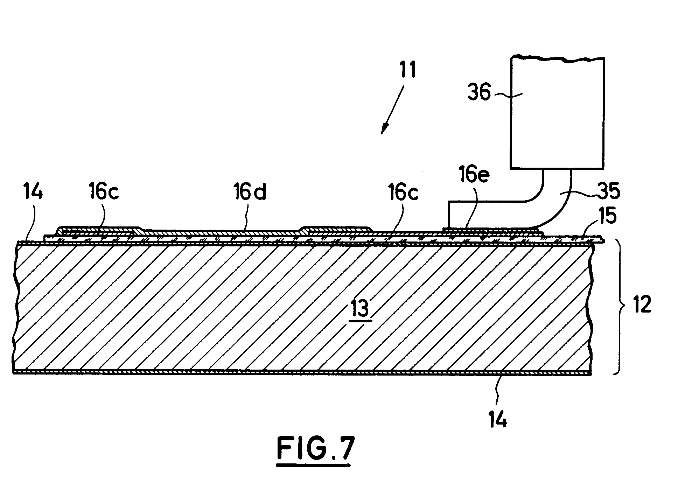

Fig. 6 zeigt ein Elektrowärmegerät 30 für die Raumbeheizung, das mehrere Elektro-Bauelemente llb enthält. Sie enthalten auf einem Träger 12 je zwei auf einer Seite angebrachte, mäanderförmig von einer Schmalseite zur anderen verlaufende Leiterbahnen 16a, 16b, mit denen ebenfalls eine zweistufige Schaltung möglich ist. Sie sind mit ihren Schmalseiten, in deren Bereich auch die Anschlüsse 17 vorgesehen sind, in U-Schienen 31 am Elektrowärmegerät 30 eingesteckt, das ein zur Konvektionsbeheizung durchbrochenes Gehäuse 32 hat. Es wäre jedoch auch möglich, die Bauelemente 11 unmittelbar als Wandpaneele für die Raumheizung zu verwenden, wobei beispielsweise noch eine zusätzliche Isolierschicht über den Leiterbahnen 16 vorgesehen sein kann. In jedem Fall haben die Bauelemente den Vorteil, daß sie eine sehr großflächige und gleichmäßige Beheizung ermöglichen, die mit niedrigen Spitzentemperaturen arbeitet, so daß es nicht zu der bei höheren Temperaturen auftretenden "Staubverbrennung" kommt, die das Raumklima negativ beeinflußt. Zum Ausgleich der unterschiedlichen Wärmeabgabe an die durch Konvektion aufsteigende Luft kann auch die Dichte der Heizleiterbelegung auf den Trägern durch Variation des Abstandes zwischen den Leiterbahnen variieren, so daß überall ideale Übertragungsverhältnisse vorliegen.

Fig. 7 zeigt einen Detailschnitt durch ein Bauelement 11c, das bezüglich des Trägermaterials 13, der Aluminiumschicht 14 und der Glasschicht 15 entsprechend Fig. 2 aufgebaut ist. Es handelt sich jedoch hierbei nicht um ein Raumheizelement, sondern um einen Träger für elektronische Anwendungen. Dementsprechend sind auf der Isolierschicht 15 Leiterbahnen 16c vorgesehen, die aus einem gut leitenden Metall gebildet sind, während, sie teilweise überdeckend, Widerstandsschichten 16d vorgesehen sind, die zwei Leiterbahnen 16c miteinander verbinden und so einen Funktions-Widerstand für eine elektrische oder elektronische Schaltung bilden. Weiterhin kann ein mit Hilfe zweier Elektroden 16c und eines Dielektrikums 16f ein Kondensator aufgedruckt werden sowie andere gängige passive Bauteile, wie z.B. eine Induktionsspule (nicht abgebildet). An einer anderen Stelle sind auf eine Leiterbahn 16c vom gut leitenden Typ zusätzliche Lötmaterialschichten 16e aufgebracht, mit denen elektrische oder elektronische Bauteile, beispielsweise Chips, wie integrierte Schaltkreise oder Kondensatoren z.B. in SMD-Technologie angelötet werden können.

Ein Verfahren zur Herstellung eines Bauelementes nach der Erfindung wird im folgenden näher beschrieben:
Auf einem handelsüblichen, unlegierten oder niedriglegierten Stahlblech mit einer Aluminium-Oberflächenschicht wird durch Siebdruck eine Paste aus Glaspulver aufgebracht, die durch Zugabe von später verdampfenden Flüssigkeiten und Bindemitteln auf Siebdruckfähigkeit eingestellt ist. Dabei wird das gewünschte Flächenmuster, beispielsweise das nach Fig. 1 oder 6, aufgebracht. Die Paste wird bei Raumtemperatur und danach bei etwas erhöhter Temperatur von beispielsweise 130 °C getrocknet und danach bei 500 bis 700 °C eingebrannt bzw. aufgeschmolzen. Eine gesamte Einbrennzeit von ca. 50 Minuten, wovon ungefähr 10 Minuten Maximaltemperatur herrscht, ist als vorteilhaft festgestellt worden. Bei entsprechend höheren Anforderungen an die Durchschlagfestigkeit und entsprechend höherer Schichtdicke der Isolierschicht 15 können auf mehrere Schichten nacheinander auf diese Weise aufgebracht werden. Danach wird, ebenfalls im Siebdruckverfahren, eine Leiterbahnpaste entsprechend dem gewünschten Leiterbahnmuster auf die Isolierschicht 15 aufgebracht. Die Leiterbahnpaste enthält feinst verteiltes Metallpulver, beispielsweise Nickel sowie unter Umständen einen Glasanteil als Bindemittel und organische oder andere verdampfende Lösungsmittel und organische Bindemittel, die beim Brennen verdampfen zur Einstellung auf Siebdruckfähigkeit. Das Trocknen und Brennen kann erfolgen wie zuvor für die Isolierschicht beschrieben.

Für Funktionsbauteile, wie sie in Fig. 7 beschrieben sind, können z.B. bei Leiterbahnen auf der Basis von Silber-Palladium zusätzlich Widerstände aus entsprechend niedriger leitendem Material sowie eine Lötpaste in gleicher Weise aufgebracht und ggf. eingebrannt werden. Danach werden die Bauelemente mit entsprechenden elektronischen Bauteilen oder Baugruppen 36 bestückt und diese werden im Ofen festgelötet. Hier ergibt sich der Vorteil der guten Wärmeableitung, einer ausgezeichneten magnetischen Abschirmung und besten mechanischen Eigenschaften. Werden für die Schaltung auch temperaturempfindliche Bauteile eingesetzt, so ist auch eine selektive Erwärmung der Lötstellen möglich; gleiches gilt auch für Reparaturzwecke. Alle Bauelemente nach der Erfindung sind mechanisch leicht durch beliebige Bearbeitungsverfahren zu bearbeiten und schaffen gleichzeitig eine Erdung des Basisteiles, wofür ein Erdanschluß 40 (Fig. 1) vorgesehen sein kann.

Die als Grundlage für das Glas verwendete dielektrische Paste auf Glasbasis kann beispielsweise einer von der Firma Ferro Corporation, Santa Barbara, Californien, USA, Abt. TFS, vertriebene Paste der Serie TCG sein. Sie schafft beim Einbrennen unter den angegebenen Bedingungen eine alkalifreie, weitgehend porenfreie und nicht kristallisierende Schicht, die ausgezeichnet auf der Aluminium-Oberflächenschicht des Trägers haftet und ihrerseits eine gut haftfähige Unterlage für die Leiterbahnbeschichtung schafft. Es hat sich herausgestellt, daß die Haftung so gut ist, daß eine Ablösung der Schichten bei Gewaltanwendung allenfalls innerhalb einer Metallschicht oder in der Grenzschicht Stahl-Aluminium 7 auftrat, jedoch nicht an der Grenzschicht Aluminium-Dielektrikum 18. Die Aluminium-Oberflächenschicht bildet eine korrosionsfeste und bis weit über den Schmelzpunkt von Aluminium beständige intermetallische Verbindung mit dem Träger durch Wärmeeinwirkung, die entweder beim Einbrennen der Schichten oder schon vorher vorgenommen werden kann.

Auch bei nur einseitiger Beschichtung des Trägers kann die Aluminium-Oberflächenschicht zur Verbesserung der Korrosionsbeständigkeit auf beiden Seiten aufgebracht sein. Der Träger hat noch den besonderen Vorteil, daß er besonders einfach und mit üblichen Werkzeugen bearbeitet werden kann.

## Patentansprüche

1. Elektro-Bauelement mit einem Träger (12) aus überwiegend Eisen enthaltendem Material, einer elektrischen Isolierschicht (15) und wenigstens einer darauf flächig angeordneten elektrischen Leiterbahn (16, 16a bis f), wobei zumindest die Isolierschicht (15) auf den Träger aufgeschmolzen bzw. aufgebrannt ist, und der Träger (12) ein Basismaterial (13) aus Eisen bzw. Stahl und eine zwischen Basismaterial (13) und Isolierschicht (15) vorgesehene Oberflächenschicht (14) aus Aluminium aufweist, dadurch gekennzeichnet, daß die Aluminium-Oberflächenschicht (14) eine Dicke zwischen 5 und 80 µm aufweist, und daß eine intermetallische Verbindungsschicht (7) zwischen der Aluminium-Oberflächenschicht (14) und dem Stahl-Basismaterial 13 des Trägers (12) und eine verstärkt Aluminiumoxid enthaltende Verankerungszone (18) im Grenzbereich zwischen Aluminiumschicht (14) und Isolierschicht (15) ausgebildet ist.

2. Elektro-Bauelement nach Anspruch 1, dadurch gekennzeichnet, daß das Basismaterial (13) un- bzw. niedriglegierter Stahl und vorzugsweise übliches Walzstahlblech ist und/oder der Träger (12) ein aluminiumplattiertes oder vorzugsweise ein feueraluminiertes Stahlblech ist.

3. Elektro-Bauelement nach Anspruch 1 oder 2, dadurch gekennzeichnet, daß die Isolierschicht (15) eine vorzugsweise alkalifreie Schicht auf Glasbasis ist.

4. Elektro-Bauelement nach einem der vorhergehenden Ansprüche, dadurch gekennzeichnet, daß die Dicke der Aluminium-Oberflächenschicht (14) 15 bis 40 µm beträgt und/oder die Isolierschicht (15) eine größere Dicke als die Aluminium-Oberflächenschicht (14), vorzugsweise eine Dicke von mehr als 20 µm, insbesondere bei 50 µm, aufweist.

5. Elektro-Bauelement nach einem der vorhergehenden Ansprüche, dadurch gekennzeichnet, daß die Isolierschicht (15) nur die von den Leiterbahnen (16, 16a bis f) eingenommenen Oberflächenbereich des Trägers (12) unterlegt und umgibt und/oder die vorzugsweise mäanderförmig angeordneten Leiterbahnen (16, 16a) in einer den Wärmeübertragungsverhältnissen angepaßten unterschiedlichen Dichte auf dem Träger (12) angeordnet sind und daß der Träger ggf. einen Erdungsanschluß (40) enthält.

6. Elektro-Bauelement nach einem der vorhergehenden Ansprüche, dadurch gekennzeichnet, daß der Träger (12) als Leiterbahn (16) einen Dickschichtwiderstand trägt, der vorteilhaft ein Metall mit stark positiver Temperaturcharakteristik (PTC), vorzugsweise Nickel, enthält.

7. Elektro-Bauelement nach einem der vorhergehenden Ansprüche, dadurch gekennzeichnet, daß das Bauelement (11) als vorzugsweise großflächig plattenförmiges Heizelement in einem Raumheizgerät (30) ausgebildet und insbesondere als mechanisch tragendes Bauteil eines Elektrogerätes ausgebildet und angeordnet ist.

8. Elektro-Bauelement nach einem der vorhergehenden Ansprüche, dadurch gekennzeichnet, daß es an Kontaktierungszonen (22) der Leiterbahnen (16) vorgesehene, vorzugsweise an Durchbrüchen des Trägers (12) angeordnete Anschlüsse (17) aufweist.

9. Elektro-Bauelement nach einem der vorhergehenden Ansprüche, dadurch gekennzeichnet, daß Leiterbahnen (16c) zumindest zum Teil aus hochleitendem, widerstandsarmen Material bestehen und mit als Schichtwiderstände ausgebildeten Leiterbahnen (16d), Dickschicht-Kapazitäten, - Induktivitäten und/oder mit Anschlüssen von elektrischen oder elektronischen Bauteilen (36) verbunden sind, mit denen das Bauelement bestückt ist.

10. Verfahren zur Herstellung von Elektro-Bauelementen, nach einem der vorhergehenden Ansprüche, dadurch gekennzeichnet, daß auf einem mit einer 5-80 µm dicken Oberflachenschicht (14) aus Aluminium versehenen Träger (12) aus Eisen, vorzugsweise von un- oder niedriglegiertem Stahl, ggf. stellenweise im Druckverfahren eine Glas enthaltende pastöse Schicht aufgebracht, diese getrocknet und bei Temperaturen zwischen 400 und 800°C, vorzugsweise zwischen 500 und 700°C eingebrannt und darauf, ggf. ebenfalls im Druckverfahren, pastöses Leiterbahnmaterial aufgebracht, getrocknet und unter den vorstehend angegebenen Bedingungen eingebrannt wird.

11. Verfahren nach Anspruch 10, dadurch gekennzeichnet, daß das pastöse Leiterbahnmaterial außer Metallpulver einen Glasanteil sowie ggf. Lösungs- und Bindemittel zur Einstellung der Druckfähigkeit enthält, daß zumindest die Isolierschicht (15) in mehreren Schichten nacheinander aufgebracht wird und/oder als eine der Leiterbahnschichten nach der Aufbringung anderer Leiterbahnen, vorzugsweise im Druckverfahren, Lötmaterialbereiche in Schichtform aufgebracht werden und nach Bestückung des Bauelementes (11) mit Bauteilen (36) eine ggf. selektive Erhitzung auf Löttemperatur erfolgt.

## Claims

1. Electrical component with a support (12) made from mainly iron-containing material, an electrical insulating layer (15) and at least one electric conductor (16, 16a to f) applied flat thereto, at least the insulating layer (15) being fused or fired on the support, characterized in that the support (12) has a base material (13) of iron or steel and a surface layer (14) of aluminium between the base material (13) and insulating layer (15), characterized in that the aluminium surface layer (14) has a thickness between 5 and 80 µm and that an intermetallic compound layer (7) is formed between the aluminium surface layer (14) and the steel base material (13) of the support (12) and a reinforced aluminium oxide-containing anchoring zone (18) in the boundary region between the aluminium layer (14) and the insulating layer (15).

2. Electrical component according to claim 1, characterized in that the base material (13) is unalloyed or low-alloyed steel and preferably conventional rolled sheet steel and/or the support (12) is an aluminium-plated steel sheet or preferably a hot-dip aluminized steel sheet.

3. Electrical component according to claims 1 or 2, characterized in that the insulating layer (15) is preferably an alkali-free, glass-based layer.

4. Electrical component according to one of the preceding claims, characterized in that the thickness of the aluminium surface layer (14) is 15 to 40 µm and/or the insulating layer (15) has a greater thickness than the aluminium surface layer (14), preferably a thickness of more than 20 µm and in particular is 50 µm.

5. Electrical component according to one of the preceding claims, characterized in that the insulating layer (15) is positioned below and surrounds only the surface regions of the support (12) taken up by the conductors (16, 16a to f) and/or the conductors (16, 16a) preferably arranged in meander-like manner are arranged with a varying density on the support (12) which is adapted to the beat transfer conditions and that the support optionally contains an earth terminal (40).

6. Electrical component according to one of the preceding claims, characterized in that the support (12) carries as a conductor (16) a thick-film resistor, which advantageously contains a metal with a highly positive temperature characteristic (PTC) and preferably nickel.

7. Electrical component according to one of the preceding claims, characterized in that the component (11) is preferably constructed as a large-area, plate-like heating element in an electric heater (30) and in particular is constructed and arranged as a mechanically supporting component of an electrical appliance.

8. Electrical component according to one of the preceding claims, characterized in that it has connections (17) on the contacting zones (22) of the conductors (16) and preferably located at openings in the support (12).

9. Electrical component according to any one of the preceding claims, characterized in that the conductors (16c) at least partly comprise high-conducting, low-resistant metal and are connected to conductors (16d) constructed as film resistors, thick-film capacitors, inductances and/or connections of electrical or electronic assemblies (36), with which the component is equipped.

10. Process for the manufacture of electrical components, according to one of the preceding claims, characterized in that to a support (12) made from iron, preferably unalloyed or low-alloyed steel provided with a 5 to 80 µm thick aluminium surface layer is zonally applied in the printing process a glass-containing pasty layer, which is dried and fired at temperatures between 400 and 800°C, preferably between 500 and 700°C and to this is applied, optionally in the printing process, pasty conductor material, which is dried and fired under the aforementioned conditions.

11. Process according to claim 10, characterized in that the pasty conductor material, apart from metal powder, contains a proportion of glass, as well as optionally solvents and binders for obtaining printability, that at least the insulating layer (15) is successively applied in the form of several coatings and/or, following the application of other conductors, as one of the conductor layers, preferably in a printing process, solder regions are applied in layer form and after equipping the component (11) with assemblies (36) there is an optionally selective heating to soldering temperature.

## Revendications

1. Elément de construction électrique comprenant un support (12) en matériau généralement ferrique, une couche d'isolation électrique (15) et au moins une piste conductrice électrique (16, 16a à f) disposée en surface, au moins la couche d'isolation (15) étant appliquée par fusion ou par cuisson sur le support (12) composé d'un matériau de base (13) en fer ou en acier et d'un matériau de surface (14) en aluminium disposé entre l'élément de base (13) et la couche d'isolation (15), **caractérisé en ce qu'**il comprend une couche de surface en aluminium (14) d'une épaisseur variant entre 5 et 80 m, une couche de liaison intermétallique (7) entre la couche de surface en aluminium (14) et l'élément de base (13) en acier du support (12), ainsi qu'une couche d'ancrage (18) ayant une teneur élevée en oxyde d'aluminium disposée dans la plage limite entre la couche d'aluminium (14) et la couche d'isolation (15).

2. Elément de construction électrique selon la revendication 1, caractérisé en ce que l'élément de base (13) est fabriqué en acier non allié ou à faible alliage, de préférence en tôle d'acier laminée classique, et/ou que le support (12) est composé d'une tôle d'acier plaquée d'aluminium ou de préférence d'une tôle d'acier aluminée.

3. Elément de construction électrique selon l'une quelconque des revendications 1 ou 2, caractérisé en ce que la couche d'isolation (15) consiste de préférence en une couche non alcaline à base de verre.

4. Elément de construction électrique selon l'une quelconque des revendications précédentes, caractérisé en ce que l'épaisseur de la couche de surface en aluminium (14) est comprise entre 15 et 40 m et/ou que la couche d'isolation (15) présente une épaisseur supérieure à celle de la couche de surface en aluminium (14) de préférence supérieure à 20 m, variant plus patriculièrement autour de 50 m.

5. Elément de construction électrique selon l'une quelconque des revendications précédentes, caractérisé en ce que la couche d'isolation (15) ne se trouve que sous la plage superficielle occupée par les pistes conductrices (16, 16a à f) du support (12) et/ou en ce que l'épaisseur des pistes conductrices (16, 16a) disposées de préférence sous la forme de méandres varie en fonction des conditions de transmission thermique du support (12) et que ce support est éventuellement muni d'une connexion de mise à la terre (40).

6. Elément de construction électrique selon l'une quelconque des revendications précédentes, caractérisé en ce que la piste conductrice (16) et le support (12) disposent d'une résistance à couche épaisse, avantageusement une couche métallique de caractéristiques thermiques fortement positives (CTP), de préférence du nickel.

7. Elément de construction électrique selon l'une quelconque des revendications précédentes, caractérisé en ce que l'élément de construction (11) est réalisé de préférence sous la forme d'une plaque chauffante de grande surface installée dans un convecteur électrique (30) et notamment comme élément de construction portant un appareil électrique.

8. Elément de construction électrique selon l'une quelconque des revendications précédentes, caractérisé en ce qu'il présente des connexions (17) disposées au niveau des zones de contact (22) des pistes (16), de préférence au niveau d'un certain nombre de perçages effectués dans le support (12).

9. Elément de construction électrique selon l'une quelconque des revendications précédentes, caractérisé en ce que certaines pistes (16c) sont constituées au moins en partie en un matériau à haute conductivité et à faible résistance et qu'elles sont reliées à des pistes constituant des résistances en couche (16d), à des capacitances et à des inductances à couche épaisse et/ou à des connexions d'un certain nombre de composants électriques ou électroniques (36) dont l'élément de construction est équipé.

10. Procédé de fabrication d'éléments de construction électriques selon l'une quelconque des revendications précédentes, caractérisé en ce que le support (12) en fer, de préférence en acier non allié ou à faible alliage, est muni d'une couche superficielle en aluminium et revêtu, à certains endroits, d'une couche pâteuse appliquée par impression et contenant du verre, cette couche étant séchée et ensuite cuite à des températures variant entre 400 et 800 °C, de préférence entre 500 et 700 °C, et en ce qu'un matériau de piste conductrice pâteux est appliqué, (également par impression), puis séché et cuit dans les mêmes conditions que celles décrites ci-dessus.

11. Procédé selon la revendication 10, caractérisé en ce que le matériau pâteux des pistes conductrices comprend, outre une poudre de métal, une partie en verre, ainsi qu'éventuellement des solvants et des liants pour permettre leur impression, en ce qu'au moins la couche d'isolation (15) est appliquée en plusieurs couches successivement et/ou que certaines zones de matériau de brasage sont appliquées pour constituer l'une des couches de pistes conductrices après application d'autres pistes conductrices, de préférence par impression par couches et que l'élément de construction (11) est chauffé à certains endroits à la température de brasage après avoir été équipé de composants (36).
